(19) **Europäisches Patentamt / European Patent Office / Office européen des brevets**

(11) **EP 3 182 141 B1**

(12) **EUROPEAN PATENT SPECIFICATION**

(45) Date of publication and mention of the grant of the patent:
**27.11.2024 Bulletin 2024/48**

(21) Application number: **16202887.2**

(22) Date of filing: **08.12.2016**

(51) International Patent Classification (IPC):
**G01R 15/08** *(2006.01)*   **G01R 15/18** *(2006.01)*
**G01R 19/00** *(2006.01)*   **G01R 19/02** *(2006.01)*
**G01R 19/22** *(2006.01)*   **H02H 1/06** *(2006.01)*
**H01F 27/42** *(2006.01)*   **H01F 38/38** *(2006.01)*

(52) Cooperative Patent Classification (CPC):
**G01R 15/183;** G01R 19/0023; G01R 19/22;
H01F 27/427; H01F 38/38; H02H 1/0007

(54) **COMPENSATION SIGNAL CIRCUIT FOR COMPENSATING MAGNETISATION ERRORS IN CURRENT TRANSFORMERS**

AUSGLEICHSSCHALTUNG ZUR KOMPENSATION VON MAGNETISIERUNGSFEHLERN IN STROMWANDLERN

CIRCUIT DE SIGNAL DE COMPENSATION POUR COMPENSER UNE ERREUR DE MAGNÉTISATION DANS UN TRANSFORMATEUR DE COURANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.12.2015 EP 15199390**

(43) Date of publication of application:
**21.06.2017 Bulletin 2017/25**

(73) Proprietor: **ABB Schweiz AG**
**5400 Baden (CH)**

(72) Inventors:
- **Hozoi, Adrian**
  **68239 Mannheim (DE)**
- **Kaul, Holger**
  **68165 Mannheim (DE)**

(74) Representative: **Maiwald GmbH**
**Elisenhof**
**Elisenstraße 3**
**80335 München (DE)**

(56) References cited:
**EP-A2- 0 289 042**     **US-A- 4 870 532**
**US-A- 5 841 264**     **US-A1- 2002 070 724**
**US-A1- 2012 176 120**

- **SLOMOVITZ D: "Electronic system for increasing the accuracy of in-service instrument-current transformers", IEEE TRANSACTIONS ON INSTRUMENTATION AND MEASUREMENT, IEEE SERVICE CENTER, PISCATAWAY, NJ, US, vol. 52, no. 2, 1 April 2003 (2003-04-01), pages 408 - 410, XP011097080, ISSN: 0018-9456, DOI: 10.1109/TIM.2003.810718**
- **NICOLA LOCCI ET AL: "A Digital Compensation Method for Improving Current Transformer Accuracy", IEEE TRANSACTIONS ON POWER DELIVERY, IEEE SERVICE CENTER, NEW YORK, NY, US, vol. 15, no. 4, 1 October 2000 (2000-10-01), XP011049959, ISSN: 0885-8977**

**Description**

The invention is about an electrical installation device, operable to connect an electric main circuit, and to achieve device functionalities, said installation device having at least one current transformer coupled to the electric main circuit, the secondary terminals of the transformer being connected to an electronic circuit, said electronic circuit being operable to process the secondary current and to employ the secondary current for achieving the device functionalities, wherein the electronic circuit comprises a rectifier to rectify the secondary current, according to the preamble of claim 1.

The invention deals with installation devices comprising electronic circuitry and one or more current transformers arranged such that it can measure the electrical current flowing in a main circuit comprising one or more conductors. The installation device may be employed for various purposes such as metering, control, monitoring, and protection of electrical equipment or electrical loads. Examples of such installation devices are electronic overload relays, circuit breakers, protective relays, motor starters, motor controllers, etc.

An important feature of installation devices is their operating current range. Wider current range allows the manufacturers of installation devices to cover a broad application range with less variants of the product, resulting in simplified offering and lower production and logistic costs. Wider current range is also desired by the user as it allows for enhanced application flexibility, simplified logistics, and lower inherent costs.

In installation devices concerned by the present invention sensing of the electrical current flowing in the main circuit is achieved by means of one or more current transformers. The secondary terminals of the transformers are connected to an electronic circuit where the secondary current is processed and employed to achieve the required functionalities of the installation device. The secondary current is usually rectified in order to simplify the sensing and processing circuits. In self-powered installation devices, such as electronic overload relays or circuit breakers, the secondary current of the transformers may also be used to power the electronic circuit. In such cases, a voltage regulator is also provided to power the electronic circuit with a regulated voltage, the voltage regulator being supplied by the secondary current of the transformers.

The current transformers employed to measure the current in the main circuit are typically the main components limiting the current range of the installation device, because their error increases both at small and high operating current values.

For optimum operation, a current transformer needs a certain amount of magnetic flux density in its ferromagnetic core in order to induce a voltage and consequently a current in the secondary circuit. This amount is called magnetization flux density and it depends on multiple parameters such as magnetic permeability and losses of the ferromagnetic core, dimensions of the ferromagnetic core, magnitude of the current in the main circuit, number of turns in the windings of the transformer, resistance of the secondary windings, and electrical load connected to the secondary terminals. The magnetization flux density causes a reduction of the secondary current and results in a current measurement error, called here magnetization error. The magnetization error increases with decreasing permeability of the ferromagnetic core of the transformer. Common materials employed in the ferromagnetic cores such as electrical steels feature low initial permeability at low magnetic fields and the permeability value increases with the magnetic field reaching a maximum value before approaching saturation. At high current values where the magnetization flux density approaches the saturation magnetic flux density Bs of the ferromagnetic material in the transformer core, a sharp drop of the magnetic permeability is caused leading to sharp increase of the current measurement error, called here saturation error. The saturation magnetic flux density $B_s$ is a physical limit for any ferromagnetic material and ranges between 0.8 Tesla and 1.9 Tesla for common materials used in the construction of current transformers. The maximum operational current of a current transformer is thus limited by the saturation error and magnetic cores with high saturation magnetic flux density are preferred when measuring high currents is needed.

The magnetization and the saturation error can by decreased by reducing the total voltage load seen by the secondary side of the current transformer, which typically comprises the voltage drop over the resistance of the secondary winding of the transformer, the voltage drop over load resistors such as the shunt resistor employed to measure the secondary current, and other possible load voltages such as from rectifiers and voltage regulator. In self-powered installation devices, the rectifier and the voltage regulator circuitry cause a "continuous" load voltage which is almost constant with the secondary current causing a magnetization error whose absolute value is almost constant versus the measured current. The "continuous" load voltage is the dominant source for the magnetization error at low currents, where the voltage drop over resistors is usually negligible. The low initial permeability of common ferromagnetic materials employed in the core of current transformers is one additional factor causing the magnetization error to increase at low currents. The minimum current where current transformer can optimally operate is thus strongly limited.

The useable operation range of current transformers is thus limited both at low and high current values because of magnetization errors and saturation errors. The magnetization error can be reduced by employing ferromagnetic materials with high initial permeability in the core of the transformer. Example of such materials are Ni-Fe magnetic alloys with around 80% Ni content, however, they feature relative high cost and moderate saturation magnetic flux density of around 0.8 Tesla. The saturation magnetic flux density of Ni-Fe alloys with approximately 50% Ni content is improved up to around 1.5 Tesla but the initial permeability is lower, and the cost of the material is still high. Nanocrystalline magnetic alloys feature high initial permeability and lower cost than Ni-Fe alloys, however, the saturation magnetic flux density of the material is still limited at around 1.2 Tesla and the fill ratio of the magnetic cores is relatively low around 0.75% to 0.8% leading to an effective saturation limit of the transformer core typically below 1 Tesla.

Electrical steels are iron based alloys which contain up to 6.5% silicon, most commonly around 3%. Electrical steels feature the best saturation magnetic flux density out of commonly available magnetic materials at around 1.9 Tesla. Their cost is significantly lower than that of Ni-Fe alloys and nanocrystalline materials, however, their initial permeability is worse but sufficient for many applications. Due to the high saturation magnetic flux density, acceptable permeability, low cost and wide availability, electrical steels are often selected for the construction of current transformers.

The magnetization and saturation errors of current transformers can be further reduced by increasing the effective cross section area of the ferromagnetic core. Increasing the effective cross section area of the ferromagnetic core and reducing the resistance of the secondary winding results in increased material usage for the core and for the winding, which is typically made with Cu wire. This implies higher volume, mass, and cost of the current transformers resulting in little design flexibility. The design of current transformers requires thus a tradeoff between operating current range, accuracy, volume, mass, and cost. Compromising some merits is typically necessary.

Document EP 0 289 042 A2 relates to a circuit breaker.

Document US 2002 070 724 A1 relates to a current transformer.

Document "Slomovitz, D.: Electronic System for Increasing the Accuracy of In Service Instrument Current Transformers. IEEE Transactions on Instrumentation and Measurement, Vol. 52, No. 2, 01.04.2003" discloses an electronic error compensator,

Thus it is the objective of the present invention to provide an electrical installation device where the magnetization error of the current transformers is drastically reduced, at low cost and with easy implementation.

The objective is achieved by an electrical installation device with the features of claim 1. So according to the invention the electrical installation device has a compensation signal circuit, said compensation signal circuit being operable to add a controlled compensation signal to the rectified secondary current.

The solution according to the present invention provides a method to reduce the magnetization error of current transformers by adding a controlled compensation signal to the rectified secondary current. The magnetization error causes a reduction of the raute mean square (rms) and of the DC values of the rectified secondary current by an approximately constant value, depending mainly on the construction of the current transformers and on the load conditions. For a given application it is thus possible to add a matching compensation signal with fixed magnitude to the rectified secondary current in order to strongly reduce the current error of the transformers. The useable operating current range of the transformers is thus significantly extended towards smaller current values. The advantage of the solution according to the invention by applying a compensation signal circuit is low cost and easy implementation due to using simple electronic circuitry. So the electrical installation device according to the invention features a wide current operation range combined with high accuracy, but at low cost of the installation device.

According to the invention, the compensation signal is a compensation current.

According to an advantageous embodiment of the invention, the compensation current has a fixed magnitude.

According to an advantageous embodiment of the invention, the compensation signal is a DC signal or a DC signal with an AC ripple.

According to an advantageous embodiment of the invention, the rectifier is a full wave rectifier with diodes.

According to an advantageous embodiment of the invention, the rectifier is a three phase full wave rectifier comprising 6 diodes

According to an advantageous embodiment of the invention, the device further comprises a shunt resistor connected in the path of said rectified current to convert it to a voltage, and an amplifier to amplify the said voltage, and at least one biasing resistor connected between one input of the amplifier and a reference signal in order to provide the compensation signal. The secondary current is thus rectified and then converted to a voltage by passing it through a shunt resistor. The current shunt may be a variable resistor such as a potentiometer to allow tuning the response of the system with respect to a rated current value. The shunt voltage is amplified and then further processed by the electronic circuitry. The electronic circuit may be implemented on one or more circuit boards and the circuitry may be based on analog electronic components, or it may use digital and mixed electronic solutions. The electronic circuitry can according to an advantageous embodiment be highly integrated into one or more components such as a microcontroller, mixed signal microcontroller, DSP, and/or ASIC.

In self-powered installation devices, the secondary current of the transformers may according to another advantageous embodiment of the invention also be used to power the electronic circuit. In such cases, a voltage regulator is also provided.

According to an advantageous embodiment of the invention, at least one biasing resistor is connected between the positive input of the amplifier and a voltage reference source featuring a higher DC voltage level than any ends of the shunt resistor.

According to an advantageous embodiment of the invention, an attenuating resistor is connected between the positive input of the amplifier and that end of the shunt resistor with the higher DC voltage value.

According to an advantageous embodiment of the invention, a further biasing resistor is connected between the negative input of the amplifier and that end of the shunt resistor with the higher DC voltage value.

According to an advantageous embodiment of the invention, the resistors connected to the amplifier for setting the gain include a variable resistor.

According to an advantageous embodiment of the invention, the biasing resistors and/or the attenuating resistor include a resistor whose value can be adjusted in production.

According to an advantageous embodiment of the invention, a voltage regulator circuit is connected in series with the shunt resistor.

According to an advantageous embodiment of the invention, the voltage regulator circuit also provides the reference source connected to one of the biasing resistors.

The invention will be described in greater detail by description of five embodiments with reference to the accompanying drawings, wherein

Figure 1    shows a solution to measure the current in a three-phase main circuit, including current transformers, a rectifier, a voltage regulator, a current shunt, and an amplifier;

Figure 2    shows an embodiment of the invention, where the biasing resistor is connected to a reference signal allowing to add a compensation signal to the signal coming from the shunt resistor;

Figure 3    shows an embodiment of the invention, where the biasing resistor is connected to a reference signal and the resistor attenuates the value of the reference signal;

Figure 4    shows an embodiment where the compensation signal is implemented by biasing both the positive and the negative inputs of the amplifier,

Figure 5    shows an embodiment where a potentiometer and a variable resistor are employed to adjust the compensation signal and the gain of the amplifier respectively;

Figure 6    shows an embodiment including three current transformers, a full-wave rectifier, a voltage regulator circuit in series with a shunt resistor, and an amplification circuit with adjustable gain and magnetization error compensation;

Figure 7    shows a prior art solution of an electrical installation device with three current transformers, a three-phase rectifier, a voltage regulator.

In the figures, same elements and functional groups or elements and functional groups with same or similar function have the same reference numerals.

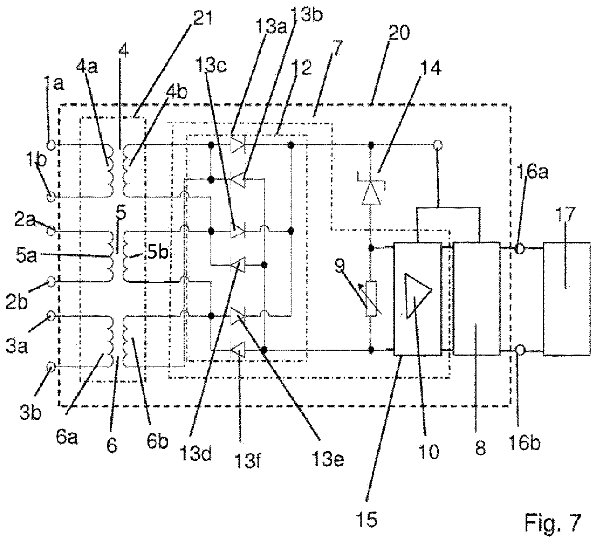

Figure 7 shows in an exemplary scheme an electrical installation device 20 according to the prior art, here in the example a three-phase electronic overload relay. It has on its input side three pairs of electrical contacts 1a, 1b; 2a, 2b; 3a, 3b operable to connect an electric main circuit. Inside the device 20, there is a three-phase current transformer unit 21, having for each phase a current transformer 4, 5, 6. Each of the transformers 4, 5, 6 is placed with its primary side 4a, 5a, 6a in series with and coupled to the electrical contacts 1a, 1b, 2a, 2b, 3a, 3b. Next, there is a sensing circuit 7 coupled to the secondary sides 4b, 5b, 6b of the current transformers 4, 5, 6. The sensing circuit 7 comprises a rectifying circuit 12 coupled to the secondary sides 4b, 5b, 6b of the transformers 4, 5, 6. The rectifying circuit 12 is a 3-phase full wave rectifier comprising six diodes 13a, 13b, 13c, 13d, 13e, 13f. Thus the sensing circuit 7 is operable to generate a voltage signal representative of the current in the main circuit.

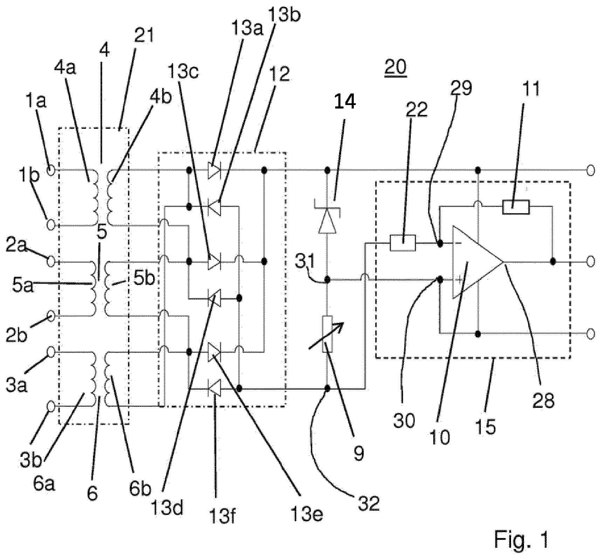

Coupled to the sensing circuit 7, there is a processing circuit 8 operable to initiate a responsive action with respect to the voltage signal representative of the current in the main circuit. The electrical installation device 20 in the example here is an electronic overload relay, having output terminals 16a, 16b operable to connect a tripping unit 17, for example a contactor. An electronic overload relay would typically also comprise an auxiliary relay driven by the processing circuit to operate the output terminals 16a, 16b; for simplicity reasons, the said auxiliary relay in not shown in figure 1. Additional output terminals for signaling may also be provided. So here in the example the responsive action of the processing circuit 8 is generating a tripping signal and delivering it to the output terminals 16a, 16b to be from there supplied to the tripping unit 17. For doing so, the processing circuit 8 may comprise an integrator and one or more comparators in order to detect fault conditions in the main circuit or in the load connected to the main circuit and to initiate responsive actions such as tripping commands and signaling. The processing circuit may comprise analog or digital electronics and implement various functionalities such as thermal models, detection of phase imbalance, and self-test.

The sensing circuit 7 has a variable shunt resistor 9 and an amplifier circuit 15 with an amplifier 10. The amplifier circuit 15 is connected to the variable shunt resistor 9 and is operable to amplify the voltage drop over the variable shunt resistor 9 and to deliver the voltage drop signal to the processing circuit 8.

In the prior art the variable shunt resistor 9 is used as a nominal current value adjustment means. Adjusting the value of the variable resistor allows tuning the response of the system with respect to a rated current value. The variable resistor 9 delivers a voltage drop that is proportional to the rectified secondary current and inversely proportional to the nominal current adjusted by the user. So a high nominal current setting means that the trip signal shall be generated in response to a high current signal only. Consequently the variable shunt resistor 9 is tuned to a low resistor value, so that the voltage drop across it and the voltage input to the amplifying circuit 15 is low, or in other words, the voltage drop needed to trigger the trip signal is achieved at very high current values only. For a low nominal current setting it is vice versa.

For self-powering the electronic circuits in the electronic overload relay 20, there is a voltage regulator 14 provided, fed from the rectifying circuit connected to the secondary side of the transformer unit 21. The voltage regulator 14 is electrically connected in series to the shunt resistance 9.

Figure 1 shows the device 20 as of figure 7, whereby the amplifier circuit 15 is explained in more detail, yet still exemplarily and schematically, using a block diagram. The amplifier circuit 15 has, here in the example, an operational amplifier 10. A feedback resistor 11 is connected between the output side 28 and the inverting input 29 of the amplifier 10. The non-inverting input 30 is connected to the one end 31 of the shunt resistor 9 which is connected to the voltage regulator 14. An input resistor 22 is connected between the inverting input 29 and the second end 32 of the shunt resistor 9. Insofar the exemplary schematic of the amplifier circuit is a conventional inverting amplifier circuit, wherein the gain is determined by the ratio of the two feedback resistors 11 and 22.

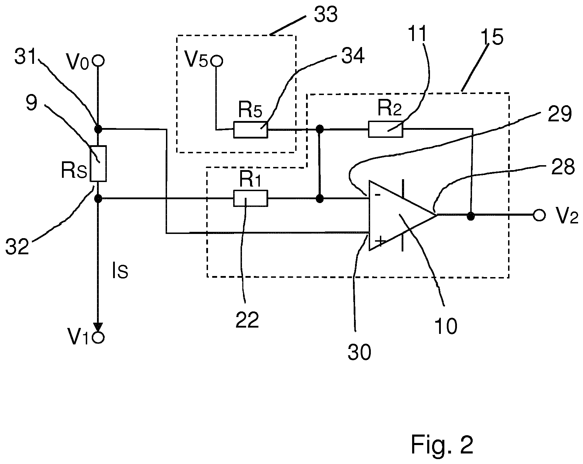

Figure 2 shows the amplifier circuit 15 in combination with a compensation signal circuit 33 according to a first embodiment of the invention. The compensation signal circuit 33 is operable to add a controlled compensation signal to the rectified secondary current. In the arrangement according to figure 2, the biasing resistor $R_5$, reference numeral 34, is connected to a reference signal $V_5$ allowing to add a compensation signal to the signal coming from the shunt resistor $R_S$., reference numeral 9.

The relation between the voltage and the secondary current passing through the shunt resistor $R_s$, reference numeral 9, can be expressed as:

$$V_1 - V_0 = -R_S I_s \qquad (1)$$

The compensation signal is created by injecting a signal into the input of the amplifier 10 that amplifies the voltage drop over the shunt resistor 9. In the arrangement shown in Fig. 2, the biasing resistor $R_5$ reference numeral 34, is connected to a reference signal $V_5$ to add a compensation signal to the signal coming from the shunt resistor $R_s$. , reference numeral 9. The output voltage is then given by the following equation:

$$V_2 - V_0 = -(V_1 - V_0)\frac{R_2}{R_1} - (V_5 - V_0)\frac{R_2}{R_5} \qquad (2)$$

The gain of the amplifier 10 is set by the input resistor $R_1$, reference numeral 22, and the feedback resistor $R_2$., reference numeral 11. The equivalent compensation current referred to the secondary current passing through the shunt resistor is deduced to be:

$$I_{sc} = -\frac{1}{R_s}\frac{R_1}{R_5}(V_5 - V_0) \qquad (3)$$

In order to obtain a positive compensation current based on Eq. 3, it is necessary to implement a reference signal $V_5$ smaller than $V_0$, such that ($V_5$ - $V_0$) is negative.

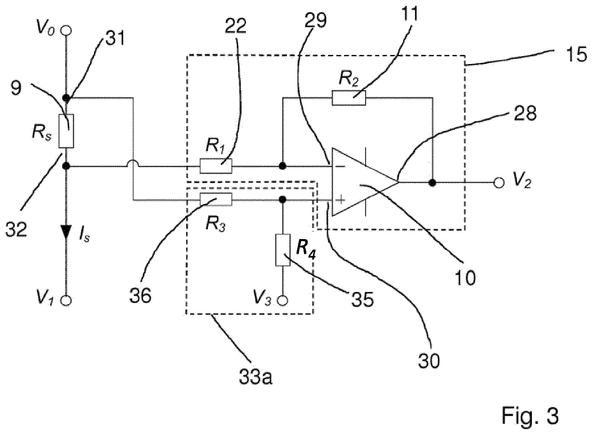

Figure 3 shows an embodiment, where the biasing resistor $R_4$ , reference numeral 35, is connected to a reference signal $V_3$ and the resistor $R_3$, reference numeral 36, attenuates the value of the reference signal, such that the compensation signal is equal to a fraction of ($V_3$ - $V_0$).

The embodiment shown in figure 3 allows implementing a positive compensation current from a positive voltage reference $V_3$, such that $V_3 > V_0$. The biasing resistors $R_4$ , reference numeral 35, is connected between the positive input of the amplifier 10 and the reference signal $V_3$. The magnitude of the required compensation signal is usually small compared to the magnitude of the signal coming from the current shunt 9 and it is practical to use an attenuator for generating it. The attenuating resistor $R_3$, reference numeral 36, is connected between the positive input 30 of the amplifier 10 and the signal $V_0$ from one end 31 of the shunt resistor 9, such that the compensation signal is equal to a fraction of ($V_3$ - $V_0$) depending on the values of the resistors $R_3$ and $R_4$. , reference numerals 36, 35 respectively. The output voltage of the amplifier 10 for the arrangement from Fig. 3 can be expressed as in Eq. 4 or 5:

$$V_2 = -V_1 \frac{R_2}{R_1} + \left(\frac{R_2}{R_1} + 1\right) \frac{V_3 R_3 + V_0 R_4}{R_3 + R_4} \tag{4}$$

$$V_2 - V_0 = -(V_1 - V_0)\frac{R_2}{R_1} + (V_3 - V_0)\left(\frac{R_2}{R_1} + 1\right)\frac{R_3}{R_3 + R_4} \tag{5}$$

The equivalent compensation current referred to the secondary current passing through the shunt resistor 9 is given then by:

$$I_{SC} = \frac{1}{R_s}\frac{R_3}{R_3 + R_4}\left(1 + \frac{R_1}{R_2}\right)(V_3 - V_0) \tag{6}$$

The compensation current from Eq. 6 corresponding to the circuit from Fig. 3 depends strongly on the gain setting of the amplifier.

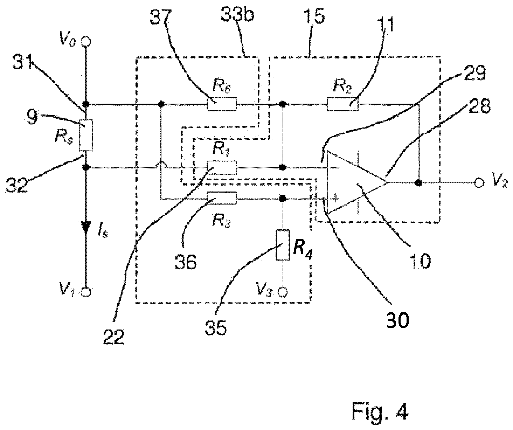

Figure 4 shows an arrangement where the compensation signal is implemented by biasing both the positive and the negative inputs of the amplifier 10, employing the resistors $R_4$ and $R_6$ , reference numerals 35, 37, respectively.

The embodiment presented in figure 4 with a compensation circuit 33b provides a better decoupling between the gain setting of the amplifier 10 and the equivalent compensation current, by connecting a further biasing resistor $R_6$ , reference numeral 37, between the negative input 29 of the amplifier 10 and the signal $V_0$. The output voltage of the amplifier 10 can be expressed as below:

$$V_2 - V_0 = -(V_1 - V_0)\frac{R_2}{R_1} + (V_3 - V_0)\left(\frac{R_2}{R_1} + \frac{R_2}{R_6} + 1\right)\frac{R_3}{R_3 + R_4} \tag{7}$$

The equivalent compensation current can then be calculated as in Eq. 8:

$$I_{SC} = \frac{1}{R_s}\frac{R_3}{R_3 + R_4}\left(1 + \frac{R_1}{R_2} + \frac{R_1}{R_6}\right)(V_3 - V_0) \tag{8}$$

The values of the resistors $R_3$, $R_4$, and $R_6$ can be tuned to minimize the dependence between the value of the compensation signal and the value of the closed loop gain of the amplifier 10. The arrangement form Fig. 4 provides great flexibility in adjusting the compensation signal and it only needs a positive voltage reference $V_3$. A positive voltage reference is preferred as it allows implementing a solution using only unipolar power supply resulting in low cost and simplicity of the electronic circuit.

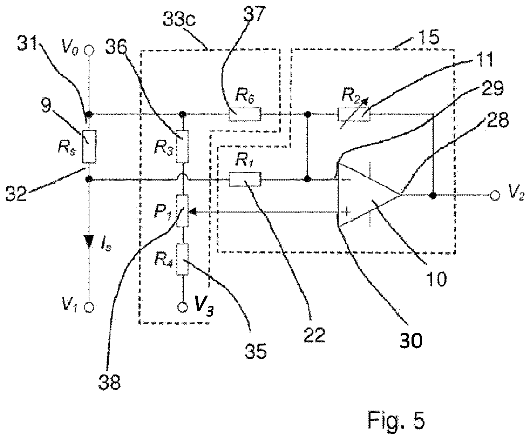

The value of the compensation signal could be fixed or variable. For example, it is possible to tune the value of the compensation signal for each device based on a calibration procedure. A one-time or multiple-times adjustable resistor 38 may be employed to that purpose for setting the value of biasing or attenuating resistors. Such arrangement is shown in Fig. 5, where a potentiometer, $P_1$, , reference numeral 38, is employed to adjust the biasing of the positive input of the amplifier 10. Other types of adjustable resistors may also be used such as rheostats, programmable resistors, or laser trimmable resistors.

A variable resistor such as a rheostat, potentiometer, or programmable resistor may also be provided to set the gain of the amplifier 10, one possible example being given in in Fig. 5. The feedback resistor $R_2$, reference numeral 11, in figure 5 is made a variable resistor and employed for setting the amplifier 10 gain. It may be controllable by the user, directly or indirectly, for adjusting the response of the installation device, for example with respect to a desired nominal current value of the main circuit.

The values of the biasing or amplifier input resistors connected to the ends of the shunt resistor 9 are typically significantly higher than the value of the shunt resistor 9 such that they divert a negligible amount of the secondary current from the shunt resistor 9. However, the current diverted by the biasing and amplifier input resistors is deterministic and can be accounted for in the design of the circuit such that the accuracy of the solution is not affected.

An operational amplifier may be employed but other types such as difference or differential amplifiers are also possible. Additional components such as capacitors could be added to the circuit for filtering or other purposes.

The solution may include one or more current transformers and a half-wave or a full-wave rectifier. For applications featuring a main circuit with 3 phases, the solution would provide best performance by including 3 current transformers and a full-wave rectifier based on 6 diodes. A voltage regulator supplied by the rectified secondary current of the transformers is provided in series with the shunt resistor for self-supplied installation devices. The common connection between the voltage regulator and the shunt may be connected to the ground of the electronic circuit, which may be a floating ground.

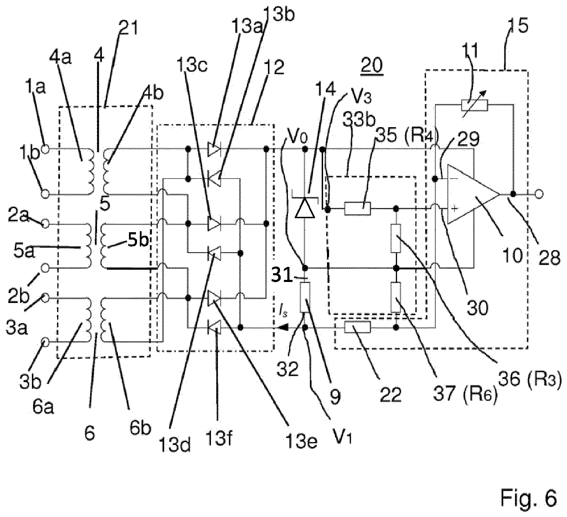

The compensation circuit is connected to the voltage reference of the voltage regulator, as shown in figure 6. Figure 6 shows an electrical installation device 20 including three current transformers 4, 5, 6, a full wave rectifier 12, a voltage regulator circuit 14 in series with a shunt resistor 9, an amplification circuit 15 with an amplifier 10 with adjustable gain using the adjustable feedback resistor 11, and a compensation signal circuit 33b, said compensation signal circuit being designed and operational like the one described in figure 4. Potential $V_0$, ground potential, in figure 4 on the top left, is in figure 6 at the common connection between the voltage regulator 14 and the shunt 9. Potential $V_3$ is at the connection point to the voltage regulator circuit 14.

Additional electronic circuitry such as an ADC or a microcontroller may be used to implement the required functionalities of the installation device. The ADC and/or the amplifier may be integrated in the microcontroller or in other type of integrated circuit such as DSP or ASIC.

List of reference signs

| | | | |
|---|---|---|---|
| 1a | electrical contact | 15 | amplifier circuit |
| 1b | electrical contact | 16a | output terminal |
| 2a | electrical contact | 16b | output terminal |
| 2b | electrical contact | 17 | tripping circuit |
| 3a | electrical contact | 20 | electrical installation device |
| 3b | electrical contact | 21 | three-phase current |
| 4 | current transformer | | transformer circuit |
| 4a | primary side | 22 | input resistor |
| 4b | secondary side | 23 | fixed value resistor |
| 5 | current transformer | 24 | fixed value resistor |
| 5a | primary side | 25 | capacitor |
| 5b | secondary side | 26 | fixed value resistor |
| 6 | current transformer | 27 | fixed value resistor |
| 6a | primary side | 28 | output side |
| 6b | secondary side | 29 | inverting input |
| 7 | sensing circuit | 30 | non-inverting input |
| 8 | processing circuit | 31 | first end of shunt |
| 9 | shunt resistor | 32 | second end of shunt |
| 10 | amplifier | 33 | compensation signal circuit |
| 11 | feedback resistor | 33a | compensation signal circuit |
| 12 | rectifying circuit | 33b | compensation signal circuit |
| 13a | diode | 33c | compensation signal circuit |
| 13b | diode | 34 | biasing resistor |
| 13c | diode | 35 | biasing resistor |
| 13d | diode | 36 | attenuation resistor |
| 13e | diode | 37 | biasing resistor |
| 13f | diode | 38 | adjustable resistor |
| 14 | voltage regulator | | |

**Claims**

**1.** An electrical installation device (20), operable to connect an electric main circuit, and to achieve device functionalities, said installation device (20) having

at least one current transformer (4) coupled to the electric main circuit,
the secondary terminals (4b) of the transformer (4) being connected to an electronic circuit,

said electronic circuit being operable to process the secondary current and to employ the secondary current for achieving device functionalities,
wherein the electronic circuit comprises a rectifier (12), with a plus terminal or voltage reference source ($V_3$) and a minus terminal ($V_1$), to rectify the secondary current, **characterized in that**
the electrical installation device (20) has a compensation signal circuit (33), said compensation signal circuit (33) being operable to add a controlled compensation signal to the rectified secondary current,
wherein the compensation circuit (33, 33b) comprises a voltage regulator circuit (14), an op-amp (10), a shunt resistor ($R_S$, 9), and five further resistors ($R_1$, 22; $R_2$, 11; $R_3$, 36; $R_4$, 35; $R_6$, 37), wherein

the voltage regulator circuit (14) is arranged between the plus terminal ($V_3$) and a ground ($V_0$),
the shunt resistor ($R_S$, 9), is arranged between the ground ($V_0$) and the minus terminal ($V_1$),
resistors $R_4$ (35) and $R_3$ (36) build a voltage divider between the plus terminal ($V_3$) and the ground ($V_0$),
the mid of $R_4$ (35) and $R_3$ (36) being connected to a non-inverting input of the op-amp (10),
resistors $R_6$ (37) and $R_1$ (22) build a voltage divider between the ground ($V_0$) and the minus terminal ($V_1$),
the mid of $R_6$ (37) and $R_1$ (22) being connected to an inverting input of the op-amp (10), and
the resistor $R_2$ (11) is arranged between an output of the op-amp (10) and the inverting input of the op-amp (10),

wherein the compensation signal is a compensation current ($I_{SC}$) through the shunt resistor (9).

2. An electrical installation device (20) according to claim 1,

wherein the compensation current (Isc) can be calculated as:

$$I_{SC} = \frac{1}{R_S} \cdot \frac{R_3}{R_3 + R_4} \left(1 + \frac{R_1}{R_2} + \frac{R_1}{R_6}\right)(V_3 - V_0)$$

with

$R_S$: resistance of the shunt resistor (9),
$R_1$ and $R_2$: resistance to set the gain of an amplifier (10) of the compensation circuit (33, 33b),
$R_3$ and $R_4$: resistance for attenuating and biasing the reference signal,
$R_6$ : resistance for biasing the inputs of the amplifier (10), and
($V_3$ - $V_0$) : the voltage of the voltage regulator circuit (14).

3. Electrical installation device (20) according to claim 2, **characterized in that** the compensation current has a fixed magnitude.

4. Electrical installation device according to claim 1 or 2, **characterized in that** the compensation signal is a DC signal or a DC signal with an AC ripple.

5. Electrical installation device (20) according to claim 1, **characterized in that** the rectifier (12) is a full wave rectifier with diodes (13a, 13b, 13c, 13d, 13e, 13f).

6. Electrical installation device (20) according to claim 5, **characterized in that** the rectifier (12) is a three phase full wave rectifier comprising 6 diodes (13a, 13b, 13c, 13d, 13e, 13f).

7. Electrical installation device (20) according to any one of claims 1 to 6, **characterized in that**
the device (20) further comprises at least one biasing resistor ($R_5$, 34) connected between an inverting input (29) of the amplifier (10) and a reference signal ($V_5$), the reference signal ($V_5$) being smaller than ground ($V_0$) such that a voltage $V_5$ - $V_0$ is negative, in order to provide the compensation signal.

8. Electrical installation device (20) according to claim 1, **characterized in that** the voltage divider between the plus terminal ($V_3$) and the ground ($V_0$), which is built by resistors $R_4$ (35) and $R_3$ (36), further comprises an adjustable resistor ($P_1$, 35) between the resistors $R_4$ (35) and $R_3$ (36), to adjust the biasing of the positive input (30) of the op-amp (10).

9. Electrical installation device (20) according to claim 1, **characterized in that** the resistors connected to the amplifier for setting the gain include a variable resistor ($R_2$, 11).

10. Electrical installation device (20) according to claim 1 or 7, **characterized in that** the biasing resistors ($R_1$, 22; $R_2$, 11; $R_3$, 36; $R_4$, 35; $R_6$, 37) include a resistor whose value can be adjusted in production.

11. Electrical installation device (20) according to any one of the preceding claims, **characterized in that** the device functionalities include functionalities of an overload relay or a motor starter or a circuit breaker.


**Patentansprüche**

1. Elektrische Installationsvorrichtung (20), die zum Anschließen eines elektrischen Hauptstromkreises und zum Erreichen von Vorrichtungsfunktionalitäten in der Lage ist, wobei die Installationsvorrichtung (20) aufweist:

   mindestens einen Stromwandler (4), der mit dem elektrischen Hauptstromkreis gekoppelt ist,
   wobei die Sekundäranschlüsse (4b) des Transformators (4) mit einer elektronischen Schaltung verbunden sind,
   wobei die elektronische Schaltung in der Lage ist, den Sekundärstrom zu verarbeiten und den Sekundärstrom zum Erreichen von Gerätefunktionen zu verwenden,
   wobei die elektronische Schaltung einen Gleichrichter (12) mit einem Pluspol oder einer Referenzspannungsquelle ($V_3$) und einem Minuspol ($V_1$) umfasst, um den Sekundärstrom gleichzurichten, **dadurch gekennzeichnet, dass**
   die elektrische Installationsvorrichtung (20) eine Kompensationssignalschaltung (33) aufweist,
   wobei die Kompensationssignalschaltung (33) in der Lage ist, dem gleichgerichteten Sekundärstrom ein gesteuertes Kompensationssignal hinzuzufügen,
   wobei die Kompensationsschaltung (33, 33b) eine Spannungsreglerschaltung (14), einen Operationsverstärker (10), einen Shunt-Widerstand ($R_S$, 9) und fünf weitere Widerstände ($R_1$, 22; $R_2$, 11; $R_3$, 36; $R_4$, 35; $R_6$, 37) umfasst, wobei

   die Spannungsreglerschaltung (14) zwischen dem Pluspol ($V_3$) und einer Masse (Va) angeordnet ist,
   der Shunt-Widerstand ($R_S$, 9), ist zwischen der Masse ($R_S$, 9) und dem Minuspol ($V_1$) angeordnet,
   die Widerstände $R_4$ (35) und $R_3$ (36) einen Spannungsteiler zwischen dem Pluspol ($V_3$) und der Masse (Va) bilden, wobei die Mitte von $R_4$ (35) und $R_3$ (36) mit einem nicht invertierenden Eingang des Operationsverstärkers (10) verbunden ist,
   die Widerstände $R_6$ (37) und $R_1$ (22) einen Spannungsteiler zwischen der Masse ($V_0$) und dem Minuspol ($V_1$) bilden, wobei die Mitte von $R_6$ (37) und $R_1$ (22) mit einem invertierenden Eingang des Operationsverstärkers (10) verbunden ist, und
   der Widerstand $R_2$ (11) zwischen einem Ausgang des Operationsverstärkers (10) und dem invertierenden Eingang des Operationsverstärkers (10) angeordnet ist,

   wobei das Kompensationssignal ein Kompensationsstrom (Isc) durch den Shunt-Widerstand (9) ist.

2. Elektrische Installationsvorrichtung (20) nach Anspruch 1,

   wobei der Kompensationsstrom (ISC) wie folgt berechnet werden kann:

   $$I_{SC} = \frac{1}{R_S} \cdot \frac{R_3}{R_3 + R_4}\left(1 + \frac{R_1}{R_2} + \frac{R_1}{R_6}\right)(V_3 - V_0)$$

   mit

   RS : Widerstand des Nebenschlusswiderstandes (9),
   $R_1$ und $R_2$: Widerstand zur Einstellung der Verstärkung eines Verstärkers (10) der Kompensationsschaltung (33, 33b),
   $R_3$ und $R_4$ : Widerstand zur Abschwächung und Vorspannung des Referenzsignals,
   $R_6$ : Widerstand für die Vorspannung der Eingänge des Verstärkers (10), und
   ($V_3$ - $V_0$): die Spannung des Spannungsregelkreises (14).

3. Elektrische Installationsvorrichtung (20) nach Anspruch 2, **dadurch gekennzeichnet, dass** der Kompensationsstrom eine feste Größe hat.

4. Elektrische Installationsvorrichtung nach Anspruch 1 oder 2, **dadurch gekennzeichnet, dass** das Kompensationssignal ist ein Gleichstromsignal oder ein Gleichstromsignal mit einer Wechselstromwelligkeit.

5. Elektrische Installationsvorrichtung (20) nach Anspruch 1, **dadurch gekennzeichnet, dass** der Gleichrichter (12) ein Vollwellengleichrichter mit Dioden (13a, 13b, 13c, 13d, 13e, 13f) ist.

6. Elektrische Installationsvorrichtung (20) nach Anspruch 5, **dadurch gekennzeichnet, dass** der Gleichrichter (12) ein Dreiphasen-Vollwellengleichrichter mit 6 Dioden (13a, 13b, 13c, 13d, 13e, 13f) ist.

7. Elektrische Installationsvorrichtung (20) nach einem der Ansprüche 1 bis 6, **dadurch gekennzeichnet, dass** die Vorrichtung (20) außerdem mindestens einen Vorspannungswiderstand ($R_5$, 34) umfasst, der zwischen einen invertierenden Eingang (29) des Verstärkers (10) und ein Referenzsignal ($V_5$) geschaltet ist, wobei das Referenzsignal ($V_5$) kleiner als Masse ($V_0$) ist, so dass eine Spannung $V_5 - V_0$ negativ ist, um das Kompensationssignal zu liefern.

8. Elektrische Installationsvorrichtung (20) nach Anspruch 1, **dadurch gekennzeichnet, dass** der Spannungsteiler zwischen dem Pluspol ($V_3$) und der Masse (Va), der durch die Widerstände $R_4$ (35) und $R_3$ (36) gebildet wird, außerdem einen einstellbaren Widerstand (P , 35) zwischen den Widerständen $R_4$ (35) und $R_3$ (36) umfasst, um die Vorspannung des positiven Eingangs (30) des Operationsverstärkers (10) einzustellen.

9. Elektrische Installationsvorrichtung (20) nach Anspruch 1, **dadurch gekennzeichnet, dass** die an den Verstärker angeschlossenen Widerstände zur Einstellung der Verstärkung einen variablen Widerstand ($R_2$, 11) umfassen.

10. Elektrische Installationsvorrichtung (20) nach Anspruch 1 oder 7, **dadurch gekennzeichnet, dass** die Vorspannungswiderstände ($R_1$, 22; $R_2$, 11; $R_3$, 36; $R_4$, 35; $R_6$, 37) einen Widerstand umfassen, dessen Wert bei der Herstellung eingestellt werden kann.

11. Elektrische Installationsvorrichtung (20) nach einem der vorhergehenden Ansprüche, **dadurch gekennzeichnet, dass** die Gerätefunktionen die Funktionen eines Überlastrelais oder eines Motorstarters oder eines Leistungsschalters umfassen.

## Revendications

1. Dispositif d'installation électrique (20), permettant de connecter un circuit électrique principal et d'obtenir des fonctionnalités de dispositif, ledit dispositif d'installation (20) comportant au moins un transformateur de courant (4) couplé au circuit électrique principal, les bornes secondaires (4b) du transformateur (4) étant connectées à un circuit électronique,

ledit circuit électronique permettant de traiter le courant secondaire et d'utiliser le courant secondaire pour obtenir des fonctionnalités de dispositif,
le circuit électronique comprenant un redresseur (12), avec une borne plus ou une source de référence de tension ($V_3$) et une borne moins ($V_1$), pour redresser le courant secondaire, **caractérisé en ce que**
le dispositif d'installation électrique (20) a un circuit de signal de compensation (33), ledit circuit de signal de compensation (33) permettant d'ajouter un signal de compensation contrôlé au courant secondaire redressé,
le circuit de compensation (33, 33b) comprenant un circuit régulateur de tension (14), un ampli-op (10), une résistance de dérivation (Rs, 9), et cinq résistances supplémentaires ($R_1$, 22 ; $R_2$, 11 ; $R_3$, 36 ; $R_4$, 35 ; $R_6$, 37),
le circuit régulateur de tension (14) étant disposé entre la borne plus ($V_3$) et une masse ($V_0$),
la résistance de dérivation (Rs, 9) étant disposé entre la masse ($V_0$) et la borne moins ($V_1$),
des résistances $R_4$ (35) et $R_3$ (36) construisant un diviseur de tension entre la borne plus ($V_3$) et la masse ($V_0$),
le milieu de $R_4$ (35) et $R_3$ (36) étant connecté à une entrée non-inverseuse de l'ampli-op (10),
des résistances $R_6$ (37) et $R_1$ (22) construisant un diviseur de tension entre la masse ($V_0$) et la borne moins ($V_1$), le milieu de $R_6$ (37) et $R_1$ (22) étant connecté à une entrée inverseuse de l'ampli-op (10), et

la résistance $R_2$ (11) étant disposée entre une sortie de l'ampli-op (10) et l'entrée inverseuse de l'ampli-op (10), le signal de compensation étant un courant de compensation ($I_{SC}$) circulant à travers la résistance de dérivation (9).

2. Dispositif d'installation électrique (20) selon la revendication 1,

dans lequel le courant de compensation ($I_{SC}$) peut être calculé par :

$$I_{SC} = \frac{1}{R_S} \cdot \frac{R_3}{R_3 + R_4} \left( 1 + \frac{R_1}{R_2} + \frac{R_1}{R_6} \right) (V_3 - V_0)$$

où

Rs : valeur de la résistance de dérivation (9),
$R_1$ et $R_2$ : valeurs de résistance pour régler le gain d'un amplificateur (10) du circuit de compensation (33, 33b),
$R_3$ et $R_4$ : valeurs de résistance pour atténuer et polariser le signal de référence,
$R_6$ : valeur de résistance pour polariser les entrées de l'amplificateur (10), et
($V_3 - V_0$): la valeur de tension du circuit régulateur de tension (14).

3. Dispositif d'installation électrique (20) selon la revendication 2, **caractérisé en ce que**
le courant de compensation a une amplitude fixe.

4. Dispositif d'installation électrique selon la revendication 1 ou 2, **caractérisé en ce que**
le signal de compensation est un signal continu ou un signal continu avec une ondulation en courant alternatif.

5. Dispositif d'installation électrique (20) selon la revendication 1, **caractérisé en ce que**
le redresseur (12) est un redresseur pleine onde ayant des diodes (13a, 13b, 13c, 13d, 13e, 13f).

6. Dispositif d'installation électrique (20) selon la revendication 5, **caractérisé en ce que**
le redresseur (12) est un redresseur pleine onde triphasé comprenant 6 diodes (13a, 13b, 13c, 13d, 13e, 13f).

7. Dispositif d'installation électrique (20) selon l'une quelconque des revendications 1 à 6, **caractérisé en ce que**
le dispositif (20) comprend en outre au moins une résistance de polarisation ($R_5$, 34) connectée entre une entrée inverseuse (29) de l'amplificateur (10) et un signal de référence ($V_5$), le signal de référence ($V_5$) étant inférieur à la masse ($V_0$) de sorte qu'une tension $V_5 - V_0$ est négative, afin de produire le signal de compensation.

8. Dispositif d'installation électrique (20) selon la revendication 1, **caractérisé en ce que**
le diviseur de tension entre la borne plus ($V_3$) et la masse ($V_0$), qui est construit par les résistances $R_4$ (35) et $R_3$ (36), comprend en outre une résistance ajustable ($P_1$, 35) entre les résistances $R_4$ (35) et $R_3$ (36), pour ajuster la polarisation de l'entrée positive (30) de l'ampli-op (10).

9. Dispositif d'installation électrique (20) selon la revendication 1, **caractérisé en ce que**
les résistances connectées à l'amplificateur pour le réglage du gain incluent une résistance variable ($R_2$, 11) .

10. Dispositif d'installation électrique (20) selon la revendication 1 ou 7, **caractérisé en ce que**
les résistances de polarisation ($R_1$, 22 ; $R_2$, 11 ; $R_3$, 36 ; $R_4$, 35 ; $R_6$, 37) incluent une résistance dont la valeur peut être ajustée en production.

11. Dispositif d'installation électrique (20) selon l'une quelconque des revendications précédentes, **caractérisé en ce que**
les fonctionnalités du dispositif comprenant des fonctionnalités d'un relais de surcharge, d'un démarreur de moteur ou d'un disjoncteur.

Fig. 1

Fig. 2

Fig. 3

Fig. 4

Fig. 5

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0289042 A2

- US 2002070724 A1

**Non-patent literature cited in the description**

- **SLOMOVITZ, D.** Electronic System for Increasing the Accuracy of In Service Instrument Current Transformers. *IEEE Transactions on Instrumentation and Measurement,* 01 April 2003, vol. 52 (2